# EUROPEAN PATENT APPLICATION

(11) **EP 1 134 858 A1**
(43) Date of publication of application: **19.09.2001**
(21) Application number: 00301819.9
(22) Date of filing: 06.03.2000
(51) Int. Cl.: H01S 5/227

(54) **Buried mesa semiconductor device**

(71) Applicant: Agilent Technologies Inc. a Delaware Corporation, Palo Alto, CA 94303 (US)
(72) Inventor: Berry, Graham Michael, Bury St Edmunds IP33 1RE (GB); Amos, Sean David, Needham Market, Suffolk IP6 8HB (GB); Bhat, Jerome Chandra, Ipswich, Suffolk IP4 2UE (GB)
(74) Representative: Coker, David Graeme

(57) **Abstract**

The present invention relates to a buried mesa semiconductor device such as a laser diode with reduced leakage currents past the heterojunction, and to a method of forming such a device. The method comprises the steps of: growing a semiconductor wafer (1) with a plurality of layers including a substrate (2) and an active layer (6); depositing a mask (52) on the wafer (1) which defines one or more mesa regions (51) ; etching the wafer (1) to remove semiconductor layers to form a mesa structure (51) above the substrate (2), each mesa region (51) having mesa sides (53,54) extending upwards from the substrate (2) and between the mesa sides (53,54) a mesa top (63,64,65); growing one or more current confining semiconductor layers (56A,59A) to cover the mesa sides (53,54); removing part of the mask (52) along a part (64,65) of the top of the mesa adjacent the mesa sides (53,54); growing a leakage current confining semiconductor layer (68A) on a previous current confining layer (59A) so that the leakage current confining semiconductor layer (68A) extends to overlie partly (64,65) the mesa top adjacent said mesa sides (53,54); and removing the residual mask (62) and growing above the mesa top (63,64,65) one or more electrical contact semiconductor layers (75) by which a confined electrical current may be applied through the mesa (51) and substrate (2).

## Description

The present invention relates to a buried mesa semiconductor device and to a method of forming such a device, and in particular to a semiconductor laser.

The fabrication and use a laser diodes in a buried heterostructure was achieved many years ago. In the field of transmitter devices for fibre-optic communication, operation is required at 1.55 *µ*m, and so such optoelectronic transmitter devices are usually fabricated from a wafer grown from an n⁻-InP substrate on which are grown a number of layers, including an undoped InGaAsP active layer, sandwiched between an upper p⁺-InP cladding layer and a lower n⁻-InP cladding layer. A mask is applied to the upper cladding layer, and the surrounding layers are etched to leave a mesa structure. Current blocking layers are then grown to cover the sides of the mesa, and after the mask is removed, further layers are grown up to a p⁺⁺-InGaAs ternary or cap layer. The cap layer has a relatively low resistance, and so serves as a contact layer to which electrical contacts may be made.

The performance of such buried heterostructure devices, such as diode lasers having pnpn (or equivalently npnp) current-blocking structures, and particularly the leakage currents, slope efficiencies, and maximum modulation speed, has been shown to depend on the size of the current leakage path around the sides of the active region.

A number of solutions have been proposed to deal with this problem. For example, see the paper by Hosoda et al, IEEE Proceedings of the 10^{th} International Conference on Indium Phosphide and related Materials, 11-15 May 1998, pp 280-283, and patent document US 5,748,659.

The paper by Hosoda proposes a method by which buried heterostructure lasers having controlled leakage current paths can be fabricated, using selective area growth of mesa structures coupled with a self-aligned mesa mask patterning step to produce lasers having a narrow, controlled leakage path. The main disadvantage of this approach is that it involves the added complication of selective area growth of the mesa structure, including an active region consisting of quantum wells, on areas of a planar wafer that must be otherwise covered by a protective mask layer. A further complication with this process is that in a subsequent step, a protective masking layer must be applied to accurately align on top of the grown mesa structure. The high precision required demands the use of a complicated self-aligned process.

Patent document US 5,748,659 proposes a scheme in which tight control of MOCVD overgrowth conditions can be used to control accurately the profile of the overgrowth so as to obtain a buried heterostructure laser having a npnp blocking structure with controlled leakage path geometry around the leakage region. Specifically, this document proposes that suppression of mass transport, or reflow, of InP during overgrowth is crucial to minimizing deformation of the original mesa shape during overgrowth. This leads to the possibility of the overgrowth of the mesa with a blocking structure of precisely controlled geometry, and hence to buried heterostructure lasers having controllable leakage path around the active region. Suppression of mass transport is achieved by growing the initial overgrowth layers at temperatures considerably lower than temperatures normally used for MOCVD growth of InP-based materials, and raising the growth temperature as the overgrowth progresses. The document suggests that further suppression of mass transport can be achieved by introducing an InGaAsP layer into the buffer material below the active region. This material forms part of the mesa structure, and it is proposed that its presence suppresses the migration of In atoms up the sides of the mesa over the InGaAsP layer, thus suppressing part of the mass transport process, and thereby further inhibiting deformation of the original mesa structure.

The main disadvantages with this method lie in the difficulty of controlling the overgrowth itself. Control over the overgrowth temperature as overgrowth progresses to the degree required by this patent is difficult to achieve in a production environment. Furthermore, the growth of planar, high-quality InP at low temperatures is in itself a difficult task. Another difficulty is that the introduction of the mass-transport-suppressing InGaAsP layer into the device structure introduces extra hetero-interfaces across which charge carriers must be injected in order to transport current from the substrate contact of the device, up through the mesa and into the active region. This potentially leads to a compromise in device performance and specifically, to higher required device operating voltages. This effect may be small in the case of lasers fabricated on n-type substrates in which the highly mobile electrons are easily injected over these heterobarriers, but could be larger in the case of lasers fabricated on p-type substrates in which the less mobile holes must be injected over these heterobarriers.

It is an object of the invention to provide a buried mesa semiconductor device, and a method of forming such a device, that deals with these issues.

Accordingly, the invention provides a buried mesa semiconductor device, comprising a semiconductor substrate, a semiconductor mesa formed upon the substrate, the mesa having an active layer, mesa. sides extending upwards from the substrate and adjacent and between the sides a mesa top, and a number of semiconductor layers grown upwards from the substrate including: one or more current confining layers covering the sides of the mesa, and above the mesa top an electrical contact semiconductor layer by which a confined electrical current may be applied through the mesa and substrate, characterised in that contiguous with said current confining layer(s) is a leakage current confining layer that extends from above the current confining layer(s) to overlie partly the mesa top adjacent said mesa sides.

The active layer(s) may be optically active, for example being a laser diode device, an electro-optical modulator, or passive optical structures such as a distributed feedback grating, or an optical waveguide.

Also according to the invention, there is provided a method of forming a buried mesa semiconductor device, comprising the steps of:
a) growing a semiconductor wafer with a plurality of layers including a substrate and an active layer;
b) depositing a mask on the wafer, which defines one or more mesa regions;
c) etching the wafer to remove semiconductor layers to form a mesa structure above the substrate, each mesa region having mesa sides extending upwards from the substrate and between the mesa sides a mesa top;
d) growing one or more current confining semiconductor layers to cover the mesa sides;
e) removing the mask and growing above the mesa top one or more electrical contact semiconductor layers by which a confined electrical current may be applied through the mesa and substrate;
characterised in that the method comprises the steps before step e) of:
f) removing part of the mask along a part of the top of the mesa adjacent the mesa sides; and
g) growing a leakage current confining semiconductor layer on a previous current confining layer so that the leakage current confining semiconductor layer extends to overlie partly the top of the mesa adjacent said mesa sides.

The mask may be a conventional inorganic mask, such as silicon dioxide or silicon nitride.

In step c), the semiconductor material may be removed by conventional wet or dry etching techniques. Preferably, the material is removed in a wet etching process, as this results in less undercutting of the mask. This in turn makes it easier to remove partly the mask along the edges of the mesa top, for the reason that less mask material overhanging the sides of the mesa has to be removed.

In step f), the mask is partly removed preferably in a wet etch process, rather than a dry etch process. The wet etch attacks the mask from all exposed sides, and so the mask recedes from the edges of the mesa top, while still leaving a reduced thickness of mask in a central portion of the mesa top. An advantage of using a wet etch in this step is that the receded edges of the mask are nearly vertical, which helps to prevent or reduce overgrowth of the mask when semiconductor material is subsequently grown over the exposed edges of the mesa top in step g).

In a preferred embodiment of the invention, the device has leakage current confining layers grown in two stages, the first stage of growth occurring before step f), and the second stage of growth occurring in step g). This permits the leakage current confining layer is thicker above the other current confining layers than above the mesa top.

Once the leakage current confining layer has been deposited on the edges of the mesa top, the remainder of the mask can be fully removed in a wet etch process.

The invention will now be described by way of example, with reference to the accompanying drawings, of which:
Figure 1 is a cross-sectional view of a conventional InP wafer prior to the processing steps for forming a buried heterostructure laser device;
Figures 2A and 2B are cross-sectional views of steps in one prior art method for forming a buried heterostructure laser device;
Figure 3A and 3B are cross-sectional views of steps in another prior art method for forming a buried heterostructure laser device;
Figures 4A to 4F show the method of forming a buried mesa semiconductor device according to a first embodiment of the invention, here a laser device; and
Figures 5A, 5B, 6A and 6B show methods of forming a buried mesa semiconductor device according to a second embodiment of the invention.

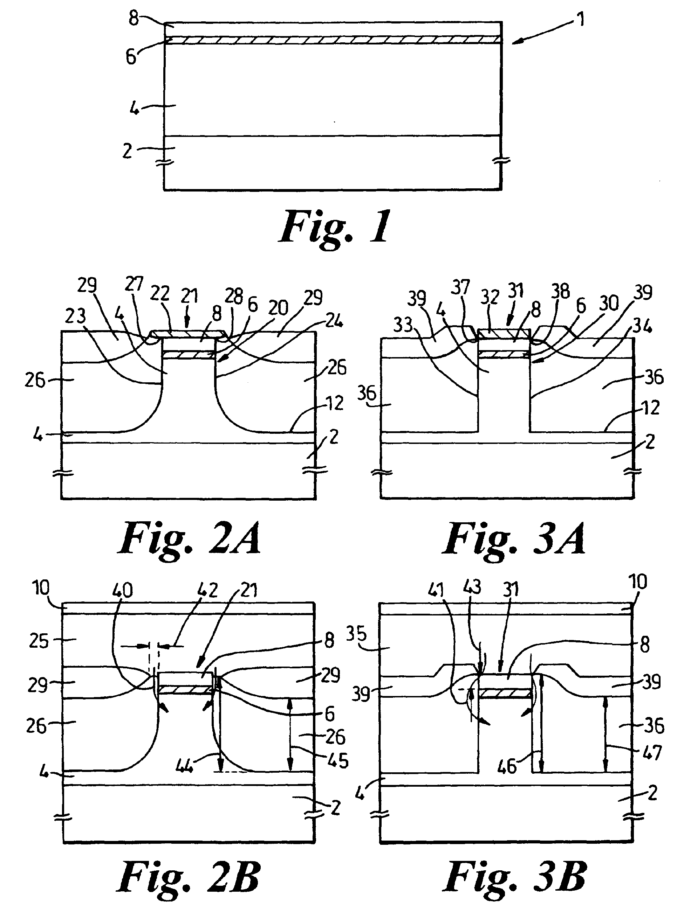

Figures 1 shows, not to scale, a prior art semiconductor wafer 1 used as a starting point in the fabrication of a buried heterostructure device. The wafer is 32 mm square, and has an n⁻⁻-InP substrate 2 doped to around 10¹⁹ cm⁻³, on which a number of layers have been grown using metal-oxide chemical vapour deposition (MOCVD) according to known techniques for fabricating planar active layers for a laser diode. The first layer grown on the substrate is a 2 *µ*m thick n⁻-InP "lower buffer" layer 4, doped to around 10¹⁸ cm⁻³. The active layer could be a bulk region or a strained multiple quantum well (SMQW) structure laser diode. An example of an SMQW device is discussed in W. S. Ring et al, Optical Fibre Conference, Vol. 2, 1996 Technical Digest Series, Optical Society of America. The type of active layer employed is not critical to the invention. Here, the active layer is a quaternary InₓGa₁₋ₓAs_{1-y}P_{y} active layer 6 which is about 100 nm to 300 nm thick. The active layer 6 is topped by another buffer layer 8, here an "upper cladding" layer formed from p⁺-InP.

Other active optical components may be included with the laser diode, for example a distributed feedback (DFB) grating can be contained in the n⁻-InP lower buffer layer 4 or in the p⁺-InP upper buffer layer 8. An electro-optic modulator may also be included, in which case the active region of the laser and the modulator usually comprises a SMQW structure.

A laser diode will also normally include an output facet (not shown) anti-reflective coated for good transmission through the facet, and a back facet (also not shown) of the laser diode may be reflectively coated or left uncoated.

The upper buffer layer 8 is grown to be about 400 nm to 1 *µ*m thick.

Then, using well-known fabrication technology, the wafer 1 is patterned and etched, for example by spinning, exposure and development of a photoresist layer which is then etched, for example by reactive ion dry etching. A buried heterojunction, indicated generally in Figures 2A and 3A by reference numerals 20 and 30, can then be formed by one of two known alternative techniques. In both cases, an SiO₂ mask layer 22,32 is deposited in a plasma enhanced chemical vapour deposition (PECVD) process to a thickness of about 0.5 to 1 *µ*m. It should, however, be noted that silicon nitride would be a suitable alternative choice to SiO₂. This mask layer 22,32 is photolithographically patterned and etched to remove the upper buffer layer 8, the active layer 6, and 1 *µ*m of the lower buffer layer except along a 3 *µ*m wide mesa or ridge stripe 21,31 defined by the patterned mask stripe 22,32. The ridge strip 21,31 therefore rises about 2 *µ*m above the surrounding surface 12.

In Figure 2A, the semiconductor layers not covered by the patterned mask stripe 22 are removed in a chemical wet etching process. This process results in thinning of the patterned mask stripe 22, and rounding of the mask stripe edges, as well as significant undercutting of the patterned mask stripe 22. The resulting mesa 21 has nearly vertical side walls 23,24 in the vicinity of the active layer 6, that curve around into the lowermost etched surface 12.

In Figure 3A, the semiconductor layers not covered by the patterned mask stripe 33 are removed in a dry vacuum process in which reactive ions bombard the wafer in a vertical direction. This results in a mesa 31 with nearly vertical side walls 33,34 extending to the lowermost etched surface 12, and little or no undercutting of the patterned mask stripe 32. The mesa side walls 33,34 can, however, suffer some slight physical damage in the dry etching process, and so it is customary to complete the etching process with a minimal wet etch stage that has the effect of polishing back the mesa side walls 33,34. As a result, the patterned mask stripe 32 is left with a slight overhang.

A number of current confining layers are then grown upon the etched wafer in MOCVD process steps. The first such layer 26,36 is a p⁺-InP layer doped to about 10¹⁸ cm⁻³. The insulating properties can be improved by doping with Fe, which acts as a trap to electrons moving up from the substrate 2. During this process, the junctions 27,28;37,38 between the patterned mask layer 22,32 and the mesa sides walls 23,24;33,34 act as pinning points in the growth of the first p-type current confining layer 26,36. so that this layer extends fully over the mesa side walls 23,24;33,34.

A second current confining layer 29,39 is then grown over the first current confining layer 26,36. This layer 29,39 is an n⁻-InP layer doped to about 10¹⁸ cm⁻³. The insulating properties can be improved by doping with S, which acts as a trap to holes moving down towards the mesa 21,31. During this process, the junctions 27,28;37,38 between the patterned mask layer 22,32 and the mesa sides walls 23,24;33,34 or point where the first p-type current confining layer 26,36 meets the mask layer, act as pinning points in the growth of the second n-type current confining layer 29,39, so that this layer extends fully over the underlying first current confining layer 26,36. Together, the first and second current confining layers 26,29;36,39 cover the mesa side walls 23,24;33,34.

In both cases, the PECVD oxide layer 22,32 is then removed with 10:1 buffered HF from the ridge stripe 21,31 to expose again the upper buffer layer 8.

A electrical contact semiconductor layer 25,35, also called a cap layer, is then grown to a thickness of about 1 *µ*m on a top surface the upper buffer layer 8 of the mesa 21,31 and leakage current confining layers 26,29;36,39. The cap layer 16 is formed from p⁺⁺-InGaAs, highly doped with Zn to around 10¹⁹ cm⁻³, in order to provide a good low resistance ohmic contact for the electrical connection, for example to a buried heterojunction laser diode. As an alternative to a ternary cap layer, it is possible to use a quaternary InGaAsP cap layer.

In the case of a laser diode device, the buried ridge stripe 20,30 has the effect of guiding an optical mode along the active region 6 within the mesa 21,31.

A metal contact 10 is provided using well known techniques, with first a TiPt layer that is deposited by E-beam, followed by a TiAu layer deposited by sputtering. This may be followed by followed a wet etch (e.g. 50:29:56 H2O:I:KI) of the Au, and a wet etch (HF) of the Ti, in photolithographically defined areas above the mesa 21,31.

After fabrication of the various layers, the prior art device is inscribed and cleaved in a conventional process. In the case of a laser diode, the device would be about 700 *µ*m long (i.e. in the direction of the ridge 21,31) and about 300 *µ*m wide.

Although not illustrated, the substrate 2 would be soldered onto a heat sink in a conventional manner, prior to bonding of wires onto contact pads.

Because the pinning points 27,28;27,28 restrict the thickness of the second n-type current confining layer 29,39, leakage currents 40,41 can pass from the electrical contact layer 25,35 into the lower buffer layer 4 of the mesa 21,31 beneath the active layer 6. In the case of the wet-etched mesa 21, the leakage current 40 flows mainly through a transverse gap 42. In the case of the dry-etched mesa 31, the leakage current 41 flows mainly through a very thin junction between the n-type current confining layer and upper cladding layer 8 of the vertical gap between. This current depends strongly on the distance 43 between the n-type current confining layer 39 and active layer 6.

Leakage currents 40,41 are known to affect adversely the performance of laser diodes, for example by reducing the maximum modulation speed and reducing the efficiency of the device in converting electrical current into light output as operating power increases.

The inventors have also discovered that the performance of buried heterostructure lasers having semi-insulating Fe-doped p⁺-InP current confining layers is degraded over time by the presence of these leakage currents. The size of the leakage path can increase over time by the diffusion of Zn from the electrical contact layer 25,35 into the Fe-doped current confining layer 26,36. Although it is known that the interdiffusion of Zn and Fe dopants in InP is effectively suppressed by the S-doped n⁻-InP current confining layer 29,39, the inventors have discovered that if the S-doped layer 29,39 is brought into too close proximity with the active layer 6 of a buried heterojunction laser diode, this starts to have a detrimental effect on laser performance. Therefore, in laser devices having semi-insulating current confining layers, there is an optimal gap width for suppressing Zn-Fe interdiffusion and leakage currents, and this width 42,43 must be tightly controlled in order to obtain lasers with optimal performance.

As can be seen from Figures 2B and 3B however, these gap dimensions 41,42 depend critically on the thickness of the first current confining layer 26,36 near the mesa 21,31. The first current confining layer 26,36 has a thickness 45,47 away from the mesa that corresponds with a calibrated thickness that the vacuum deposition process is set to produce. The thickness 44,46 near the mesa is, however, greater than this, and has been found to depend critically on the exact mesa profile and overgrowth conditions. Furthermore, the n-type current confining layers naturally thin down towards the mesa 21,31, and it is difficult in a production process to control the exact form of this thinning. Leakage current through the thin edges of the n-type current confining layer can therefore vary widely. Control of an effective resulting leakage path or gap size 42,43 is still therefore difficult to achieve.

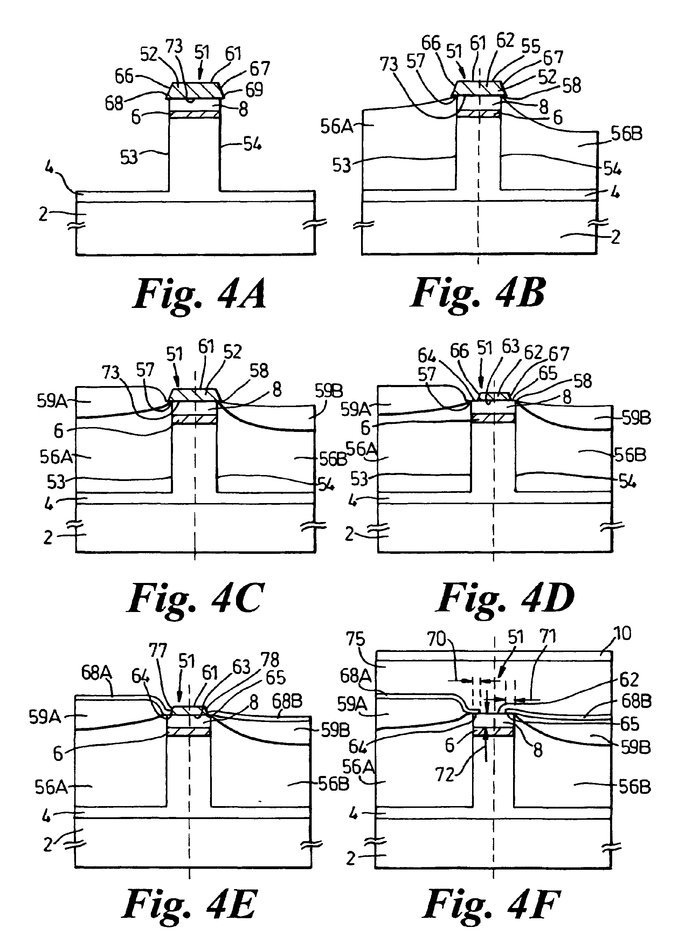

Figures 4A to 4F show the process steps in the fabrication of a buried heterostructure device for two cases of a first embodiment of the invention. Figure 4A shows an etched mesa 51 similar to that of Figure 3A, with a SiO₂ etched mask stripe 52. The mask is about 1.5 *µ*m thick, and 3 *µ*m wide.

As shown in Figure 4B, a first current confining layer is then grown upon the surface 12 of the etched wafer and over mesa side surfaces 53,54 in MOCVD process steps. The first such layer is a p⁺-InP layer 56A or 56B, doped with Fe to about 10¹⁸ cm⁻³. Each of Figures 4B to 4F show two different cases separated in each of the drawings by a vertical dashed line. On the left hand side of each figure, the p⁺-InP layer 56A is grown to a greater thickness than the p⁺-InP layer 56B on the right hand side of the figure. In both cases the thickness of the first current confining layer drops away from a corresponding pinning point 57,58 below the mask 52.

Figure 4C shows the structure after a second current confining layer 59A,59B is grown over the first current confining layer 56A,56B. This layer 59A,59B is an n⁻-InP layer doped with S to about 10¹⁸ cm⁻³. Again, the junctions 57,58 between the patterned mask layer 52 and the mesa sides walls 53,54 or point where the first p-type current confining layer 56A,56B meets the mask layer, act as pinning points in the growth of the second n-type current confining layer 59A,59B, so that this layer extends fully over the underlying first current confining layer 56A,56B. Together, the first and second current confining layers 56A,59A;56B,59B cover the mesa side walls 53,54.

On both the left and right hand sides of Figure 4C, the second current confining layer 59A,59B has been grown to the same thickness. Because of the greater thickness of the first current confining layer 56A, on the left hand side of the drawing, the second current confining layer 59A rises above the corresponding pinning point 57. On the right side of the drawing, the second current confining layer 59B is at about the same level at the corresponding pinning point 58.

In a prior art buried heterojunction device, such a variation between devices would cause unacceptable variation in leakage currents. Figures 4D, 4E and 4F show how this problem is dealt with by the invention.

First, as shown in Figure 4D, the mask stripe 52 is partially removed using 10:1 buffered HF from the mesa stripe 51 to leave a residual mask stripe 62 covering a centre top surface 63 of the mesa, with two edge top surfaces 64,65 either side of this being exposed. The width 70,71 of each exposed area is 400 nm, but may be between about 200 nm and 500 nm for a mesa that is about 3 *µ*m wide.

The wet etch leaves receded mask edges 66,67 which rise nearly vertically from the exposed mesa edge top surfaces 64,65.

As shown in Figure 4E, the next process step is the deposit by MOCVD of a third n⁻-InP current confining layer 68A,68B, which is similar in composition to the second current confining layer 59A,59B, but thinner, typically 200 nm thick. Because of the similarity of these layers 59A,68A;59B,68B the leakage current confining layer 68A can be thought of as combining with the similar underlying current confining layer 59A so that the combined thickness of the leakage current confining layer and underlying current confining layer is thicker above the other current confining layer(s) 56A than above the mesa top 63,64,65.

In growing this third current confining layer 68A,68B, the junctions 77,78 between the mesa top edges and the residual mask 62 act as pinning points. Because the structure must be removed from vacuum processing equipment during the wet etch of the original mask stripe 52, the deposition of the second current confining layer 56A,56B is terminated with the growth of a very thin p-type surface layer (not shown). This helps establish the regrowth in vacuum of the third current confining n-type layer 68A,68B.

The residual mask 62 can then be completely removed in a wet etch process using buffered HF as described above.

As shown in Figure 4F, a 1 *µ*m thick p⁺⁺-InGaAs Zn-doped electrical contact layer 75 and TiPt/TiAu electrical contact 10 are then deposited in a similar manner to that described above.

Because the residual mask stripe 62 does not cover the mesa top edges 64,65, the third current confining layer 68A,68B extends beyond the second current confining layer 59A,59B to overlap the mesa top surface edges 64,65 by about 400 nm, as well as the thinnest portions of the second current confining layer 59A,59B adjacent the mesa 51. The 200 nm thickness of the third current confining layer 68A,68B effectively restricts leakage current through the thinnest portion of the second current confining layer 59A,59B adjacent the mesa 51, and through the mesa edge areas 64,65 into the first current confining layer 56A,56B. Although there will still be some residual leakage current, the residual current leakage path is determined by the thickness of the original upper buffer layer 8, and by the extent of the partial horizontal etch-back of the mesa stripe 52. It is therefore possible to fabricate a buried heterostructure device having a pair of long, thin and therefore highly resistive residual current leakage paths.

As can be seen from a comparison of the left and right hand sides of Figure 4F, because of the effect of the pinning points 57,58, a substantial difference in overall thickness of the current confining layers 56A,59A,68A; 56B,59B,68B does not affect the optimal vertical gap 72 between the n⁻-InP current confining layers 59A,68A;59B,68B and the active layer 6, or prevent the third current confining layer 68A,68B from consistently blocking any current leakage gap past the mesa 51.

The presence of the third current confining layer 68A,68B also effectively eliminates interdiffusion of Fe from the first current confining layer 56A, 56B and Zn from the electrical contact layer 75. This helps to maintain the high resistivity of Fe-doped InP, which has the practical effect of extending device lifetime.

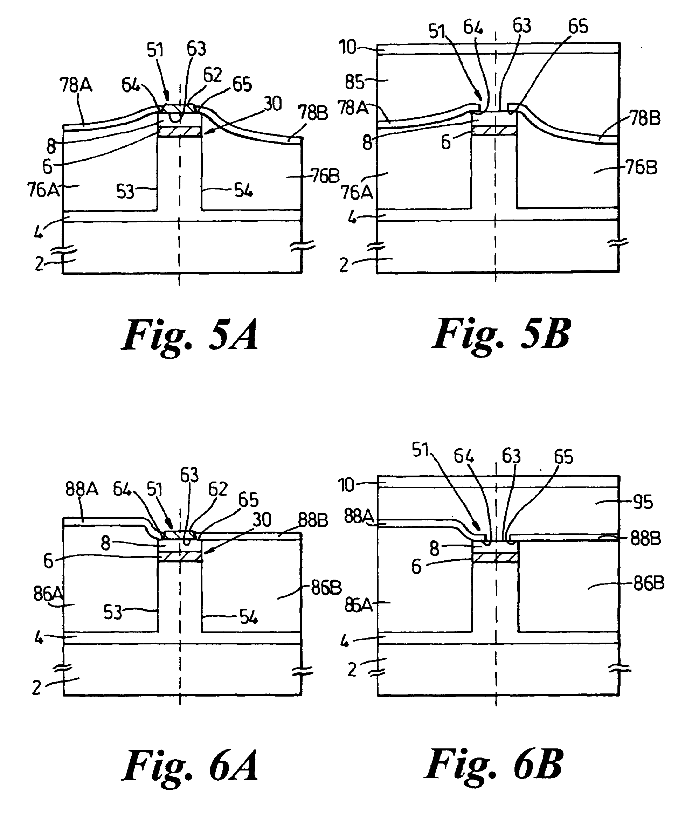

Figures 5A, 5B, 6A and 6B show methods of forming a buried mesa semiconductor device according to a second embodiment of the invention. Again, each drawing shows two cases in which a first p⁺-InP layer 76A,76B;86A,86B is grown to two different thickness. Again, the invention accommodates a significant variation in the thickness and profile of the first current confining layer 76A,76B;86A,86B. The difference between the second embodiment and the first embodiment described above, is that there is only one additional n⁻-InP layer 78A,78B;88A,88B, deposited after the horizontal etch back of the mask stripe 52. This n-type layer 78A,78B;88A,88B extends over the first current confining layer to cover the exposed top edges 64,65 of the mesa 51. Because there is no underlying n-type layer, the current confining layer 76A,76B,86A,86B is thicker, at between 400 nm and 1 *µ*m.

The residual mask 63 can then be completely removed in a wet etch process using buffered HF as described above.

As shown in Figures 5B and 6B, a 1 *µ*m thick p⁺⁺-InGaAs Zn-doped electrical contact layer 85,95 and TiPt/TiAu electrical contact 10 are then deposited in a similar manner to that described above.

Although not illustrated, after the fabrication of the structures shown in Figures 4F, 5B and 6B, individual devices can be cleaved, and then the substrate 2 soldered onto a heat sink in a conventional manner, prior to bonding of wires onto contact pads.

The different embodiments of the buried heterostructure invention allow the process conditions in the deposition of underlying current confining layers to be relaxed, while at the same time allowing close control of residual leakage currents through layer thickness control in the fabrication of the original wafer. The invention can also reduce interdiffusion or dopants through leakage current gaps, thereby increasing the operational stability of the device over time.

It is particularly convenient that no separate mask alignment step is needed to create the residual mask and exposed mesa side edges.

Although the invention has been described in terms of an In-P wafer with an n⁻⁻-InP substrate, the invention is also applicable to devices based on a semiconductor p-type substrate. In this case, the doping of each layer is inverse to that described above.

## Claims

1. A buried mesa semiconductor device, comprising a semiconductor substrate (2), a semiconductor mesa (51) formed upon the substrate (2), the mesa (51) having an active layer (6), mesa sides (53,54) extending upwards from the substrate (2) and adjacent and between the sides (53,54) a mesa top (63,64,65), and a number of semiconductor layers (4,6,8) grown upwards from the substrate (2) including: one or more current confining layers (56A,59A) covering the sides (53,54) of the mesa (51), and above the mesa top (63,64,65) an electrical contact semiconductor layer (75) by which a confined electrical current may be applied through the mesa (51) and substrate (2), **characterised in that** contiguous with said current confining layer(s) (56A,59A) is a leakage current confining layer (68A) that extends from above the current confining layer(s) (56A,59A) to overlie partly (64,65) the mesa top (51) adjacent said mesa sides (53,54).

2. A buried mesa semiconductor device as claimed in Claim 1, in which the active layer (6) is an optically active layer.

3. A buried mesa semiconductor device as claimed in Claim 2, in which the device is a laser diode device.

4. A buried mesa semiconductor device as claimed in any preceding claim, in which the leakage current confining layer (68A) is combined with a similar underlying current confining layer (59A) so that the combined thickness of the leakage current confining layer (68A) and underlying current confining layer (59A) is thicker above the other current confining layer(s) (56A) than above the mesa top (63,64,65).

5. A method of forming a buried mesa semiconductor device, comprising the steps of:
a) growing a semiconductor wafer (1) with a plurality of layers including a substrate (2) and an active layer (6);
b) depositing a mask (52) on the wafer (1) which defines one or more mesa regions (51) ;
c) etching the wafer (1) to remove semiconductor layers to form a mesa structure (51) above the substrate (2), each mesa region (51) having mesa sides (53,54) extending upwards from the substrate (2) and between the mesa sides (53,54) a mesa top (63,64,65);
d) growing one or more current confining semiconductor layers (56A,59A) to cover the mesa sides (53,54);
e) removing the mask (52) and growing above the mesa top (63,64,65) one or more electrical contact semiconductor layers (75) by which a confined electrical current may be applied through the mesa (51) and substrate (2);
**characterised in that** the method comprises the steps before step e) of:
f) removing part of the mask (52) along a part (64,65) of the top of the mesa adjacent the mesa sides (53,54); and
g) growing a leakage current confining semiconductor layer (68A) on a previous current confining layer (59A) so that the leakage current confining semiconductor layer (68A) extends to overlie partly (64,65) the top of the mesa adjacent said mesa sides (53,54).

6. A method as claimed in claim 5, in which the semiconductor material in step c) is removed in a dry etching process.

7. A method of forming a buried mesa semiconductor device as claimed in Claim 5 or Claim 6, in which the device has leakage current confining layers (56A,59A) grown in two stages, the first stage of growth occurring before step f), and the second stage of growth occurring in step g).

8. A method of forming a buried mesa semiconductor device as claimed in any of Claims 5 to 7, in which in step e) the mask (62) is removed in a wet etch process.

9. A method of forming a buried mesa semiconductor device as claimed in any of Claims 5 to 8, in which in step f) the mask (52) is removed in a wet etch process.

10. A method as claimed in any of Claims 5 to 9, in which the semiconductor device is based on III-V elements.
